**Europäisches Patentamt**

**European Patent Office**

**Office européen des brevets**

(19)

(11) Veröffentlichungsnummer: **0 040 423**
**A2**

(12) # EUROPÄISCHE PATENTANMELDUNG

(21) Anmeldenummer: 81103804.1

(22) Anmeldetag: 18.05.81

(51) Int. Cl.³: **H 01 L 27/10**
**H 03 H 15/02, H 01 L 29/78**

(30) Priorität: 21.05.80 DE 3019437

(43) Veröffentlichungstag der Anmeldung:
25.11.81 Patentblatt 81/47

(84) Benannte Vertragsstaaten:
AT BE CH FR GB IT LI NL SE

(71) Anmelder: SIEMENS AKTIENGESELLSCHAFT Berlin
und München
Postfach 22 02 61
D-8000 München 22(DE)

(72) Erfinder: Betzl, Hermann, Dipl.-Ing.
Albert-Rosshaupter-Strasse 130
D-8000 München 70(DE)

(72) Erfinder: Pfleiderer, Hans-Jörg, Dr.-Ing.
Franz-Krinninger-Weg 23
D-8011 Zorneding(DE)

(72) Erfinder: Schreiber, Roland, Dr.-Ing.
Hohenbrunnerstrasse 61
D-8012 Ottobrunn-Riemerling(DE)

(54) **Aus mehreren CTD-Elementen bestehende CTD-Leitung.**

(57) Die Erfindung betrifft eine aus mehreren CTD-Elementen bestehende CTD-Leitung, bei der zur Ladungsaufteilung in Richtung des Ladungstransports verlaufende Trennstege (DOX), insbesondere nach Art von Dickoxid-Stegen oder channel-stop-Gebieten, aufebracht sind.

Aufgabe der Erfindung ist es, Möglichkeiten zur Ladungsaufteilung anzugeben, nach denen an sich jedes beliebige Teilungsverhältnis realisierbar ist, ohne daß der Einfluß von Herstelltoleranzen störend in Erscheinung tritt.

Erfindungsgemäß wird diese Aufgabe dadurch gelöst, daß zur Erzielung eines vorgegebenen Ladungsaufteilungsverhältnisses die Ladungsaufteilung in mehr als einem Schritt erfolgt, derart, daß für aufeinanderfolgende Teilungsschritte die Trennstege (DOX) so angeordnet sind, daß sich für den einzelnen Schritt eine Ladungsaufteilung im Verhältnis von etwa 1:1 ergibt, und daß zwsichen den Teilungsstufen ($A_1$, $B_1$, $A_1$, $B_1$, $A_2$, $B_2$, $A_3$, $B_3$) Summations-Abschnitte ($C_1$, $C_2$, $C_3$) vorgesehen sind, in denen mit Ausnahme von nur einer Teilladung ($A_1$, $A_2$, $A_3$) sämtliche übrigen Teilladungen ($B_1$; $B_1+B_2$; $B_1+B_2+B_3$) summiert werden.

./...

SIEMENS AKTIENGESELLSCHAFT

Berlin und München

Unser Zeichen

VPA 80 P 6 5 9 4 - E

## Aus mehreren CTD-Elementen bestehende CTD-Leitung

Die Erfindung betrifft eine aus mehreren CTD-Elementen bestehende CTD-Leitung, bei der zur Ladungsaufteilung in Richtung des Ladungstransportes verlaufende Trennstege, insbesondere nach Art von Dickoxid-Stegen oder channel-stop-Gebieten, aufgebracht sind.

CTD-Elemente und CTD-Leitungen der vorgenannten Art sind beispielsweise aus der Zeitschrift "Elektronik" 1974, Heft 1, Seiten 3 bis 8, bekannt geworden. Dort ist in dem Aufsatz "Ladungsverschiebeschaltungen" im einzelnen die Wirkungsweise solcher CTD-Schaltungen behandelt und es ist auch darauf hingewiesen, daß darunter sogenannte Eimerkettenschaltungen, nämlich BBD-Schaltungen und auch sogenannte ladungsgekoppelte Schaltungen, nämlich sogenannte CCD-Schaltungen zu verstehen sind. Die Abkürzungen CTD bzw. BBD bzw. CCD sind dabei aus der englischen Fachliteratur übernommene Abkürzungen, die die Bedeutung "Charge Transfer Devices" bzw. Bucket Brigade Devices" bzw. "Charge Coupled Devices" haben. Weiterhin sind solche CTD-Leitungen auch aus dem Buch "Charge Transfer Devices" (Verfasser Séquin und Tompsett, Academic Press, New York, San Francisco, London 1975,) bekannt geworden. Insbesondere auf den Seiten 43 und 44 ist darauf hingewiesen, daß außer den Dickoxid-Stegen auch sogenannte "channel-stop-diffusion-Gebiete" als Trennstege vorgesehen werden können. Auch Kombinationen dieser beiden Methoden sind möglich.

Es lassen sich solche Ladungsverschiebeschaltungen auch zur Realisierung von integrierten Filterschaltungen verwenden, wozu nur beispielsweise auf die deutschen

Hka 1 Toi / 20.05.1980

Patentschriften Nr. 24 53 669 und Nr. 25 55 835 hingewiesen sei. In den beiden vorgenannten Patentschriften sind Schaltungen angegeben, für die auch formelmäßig dargestellt ist, daß zu deren Realisierung CTD-Leitungen erforderlich sind, die zueinander ein fest vorgegebenes Kapazitätsverhältnis haben. Wenn bei den dort beschriebenen Filterschaltungen die Aufgabe auftritt, Filter mit verhältnismäßig geringer Bandbreite zu realisieren, dann unterscheiden sich auch die Kapazitätsverhältnisse der zu verwendenden CTD-Leitungen erheblich, was wiederum zu Schwierigkeiten hinsichtlich der zu beherrschenden Toleranzen bei dem technologischen Herstellungsprozeß führt. Es hängt dies damit zusammen, daß beim Herstellungsprozeß solche Toleranzen, die beispielsweise bei den zu verwendenden Masken als auch beim Technologieprozeß auftreten, zu Veränderungen in der Kanalweite und der Elektrodenlänge solcher CTD-Anordnungen führen. Dadurch ergeben sich auch Streuungen in den aktiven Elektrodenflächen. Die Ladungsaufteilung erfolgt nun im Verhältniß der Elektrodenkapazitäten, so daß sich also solche Toleranzen unmittelbar auch auf die Filtercharakteristik auswirken. Die vorstehend genannten Literaturstellen sind hier nur als Beispiel anzusehen, denn es tritt auch bei anderen solchen CTD-Leitungen immer wieder die Aufgabe auf, Ladungen aufzuteilen, und zwar in einem vorgebbaren Verhältnis.

Der Erfindung liegt die Aufgabe zugrunde, eine aus mehreren CTD-Elementen bestehende CTD-Leitung anzugeben, mit der es gelingt, jedes beliebiges Teilungsverhältnis zu realisieren, ohne daß zugleich der Einfluß der Toleranzen störend in Erscheinung tritt.

0040423

80 P 6594 E

Gemäß der Erfindung wird diese Aufgabe dadurch gelöst, daß zur Erzielung eines vorgegebenen Ladungsaufteilungsverhältnisses die Ladungsaufteilung in mehr als einem Schritt erfolgt, derart, daß für aufeinanderfolgende Teilungsschritte die Trennstege so angeordnet sind, daß sich für den einzelnen Schritt eine Ladungsaufteilung im Verhältnis von etwa 1:1 ergibt, und daß zwischen den Teilungsstufen Summations-Abschnitte vorgesehen sind, in denen mit Ausnahme von nur einer Teilladung sämtliche übrigen Teilladungen summiert werden.

Als vorteilhafte Ausgestaltung kann dabei daran gedacht werden, für den den kleineren Ladungsanteil führenden Teilzweig eine Kanalaufweitung vorzusehen.

Wie bereits erwähnt, wird dabei von der Überlegung ausgegangen, an sich jedes beliebige Teilungsverhältnis mittel mehrerer, kumulativ wirkender Teilungsverhältnisse von jeweils etwa 1:1 zu realisieren.

Auch wurde einleitend bereits auf Literaturstellen hingewiesen, in denen unter anderem auch dargestellt ist, daß zur Realisierung solcher ladungsgekoppelter Schaltungen Schichten aus Dünnoxid und Dickixid zur Isolierung der Elektroflächen verwendet werden.

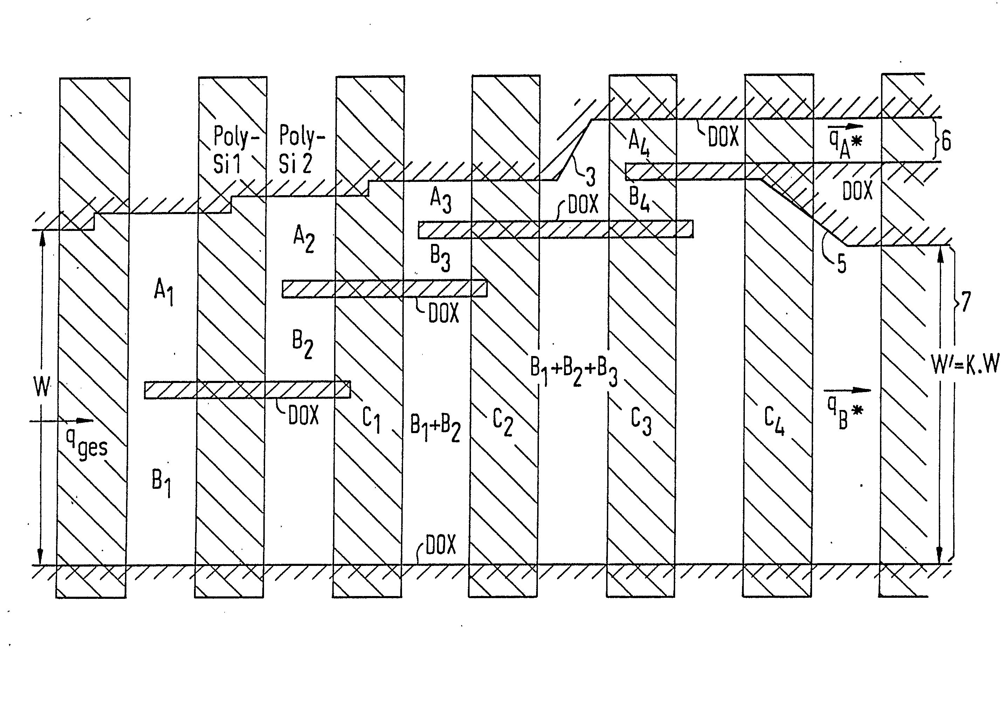

In der beigefügten Figur ist das Schema einer 4-stufigen Ladungsaufteilung mit z.B. einem Teilungsverhältnis A:B je Stufe dargestellt. Die Trennung der Ladungspakete erfolgt jeweils z.B. durch Dickoxidstege. Um ein Ansteigen der Flächenladungsdichte zu vermeiden, muß die Kanalweite mit jedem Dickoxidsteg vergrößert werden. Vorteilhafterweise wird die Ladungsaufteilung und Kanalaufweitung unter verschienen Elektroden vor-

-4-  VPA  80 P 6 5 9 4 E

genommen. Der Ladungsanteil $A_i$ wird bei der nächsten Stufe z.B. im Verhältnis $A:B = A_{i+1}:B_{i+1}$ geteilt, wobei anschließend die Ladungen unter den B-Flächen summiert werden.

Für beliebige Teilungsverhältnisse $A_i:B_i$ gilt allgemein:

$$\frac{q_A}{q_{ges}} = \frac{A_1}{(A_1+B_1)} \times \frac{A_2}{(A_2+B_2)} \times \cdots \times \frac{A_n}{(A_n+B_n)} = \prod_{j=1}^{n} \frac{A_j}{(A_j+B_j)}$$

$$K = \frac{q_B}{q_{ges}} = 1 - \frac{q_A}{q_{ges}} \; ; \quad K = 1 - \prod_{j=1}^{n} \left[ \frac{A_j}{(A_j+B_j)} \right]$$

Hierin bedeuten n die Zahl der Aufteilungsschritte, d.h. der Stufen, und j eine Zählvariable.

Für n Stufen mit jeweils gleichem Aufteilungsverhältnis A/B gilt für die resultierende Ladung $q_A$ am Ausgang:

$$q_A = q_{ges} \left(\frac{A}{A+B}\right)^n$$

Analog gilt für den Aufteilungsfaktor K:

$$K = \frac{q_B}{q_{ges}} = 1 - \left(\frac{A}{A+B}\right)^n$$

Bei schmalen Kanälen oder großen Teilungsverhältnissen, d.h. vielen Stufen, muß der CCD-Kanal für die letzten Stufen aufgeweitet werden, damit die technologisch bedingte Kanalweite nicht unterschritten wird. Diese Aufweitung wird anschließend im Kanal B wieder rückgängig gemacht. Auf diese Weise läßt sich eine konstante Flächenladungsdichte erhalten. Der Einfluß des schlechteren Übertragungsbeiwertes $\mathcal{E}$ der Kanalaufweitung ist gering, da nur ein kleiner Ladungsanteil für wenige Elemente davon betroffen ist.

Die Figur läßt ferner erkennen, daß am Eingang der CTD-Leitung die Ladung $q_{ges}$ in die CTD-Leitung fließt und daß dort eine Kanalbreite W eingestellt ist, die durch Dickoxidschichten DOX begrenzt wird. Es ist dabei davon auszugehen, daß die mit Poly-Si1 und Poly-Si2 bezeichneten Flächen als Elektrodenflächen zu denken sind, die sich gegenseitig abwechseln und die sich gegebenenfalls überlappen können. Die einzelnen Teilladungen sind mit A bzw. B bezeichnet, wobei in jeder Stufe bereits durch entsprechende Indizes kenntlich gemacht ist, wie sich die einzelnen Teilladungen aufteilen bzw. addieren. Die Ladungsaufteilung erfolgt also in mehr als einem Schritt und es sind hierfür in Richtung des Ladungstransportes verlaufende Dickoxid-Stege vorgesehen, die ebenfalls mit DOX bezeichnet sind und die jeweils so angeordnet sind, daß für aufeinanderfolgende Teilungsschritte etwa eine Ladungsaufteilung im Verhältnis von 1:1 erfolgt. Unmittelbar aus der Figur sind auch die Summationsabschnitte $C_1$ bis $C_3$ zu erkennen, in denen mit Ausnahme von nur einer Teilladung sämtliche übrigen Teilladungen $B_1$, $B_1+B_2$, $B_1+B_2+B_3$ summiert werden. Wie vorstehend bereits erwähnt, kann im Bereich 3 der KanalA dann aufgeweitet werden, wenn das zu erzielende Teilungsverhältnis besonders groß sein soll, wodurch der Ausgang 6, an dem die Ladung $q_{A*}$ erscheint, als CTD-Leitung realisierbar ist, deren Herstellungstoleranzen noch gut beherrschbar sind. Für die Ladungsanteile B wird im Ausführungsbeispiel im Bereich 5 wiederum eine Korrektur der Kanalaufweitung in der Weise vorgenommen, daß in diesem Bereich der Kanal eine kleinere Breite $W' = K \cdot W$ erhält, und zwar entsprechend der für K bereits angegebenen Formel. Durch diese Maßnahme läßt sich eine konstante Flächenladungsdichte erreichen. Wie ebenfalls unmittelbar aus der Figur zu erkennen ist, wird am Ausgang 7 demzufolge die Ladung $q_{B*}$ erscheinen. Es gilt demzufolge auch $K = q_{B*}/q_{ges}$.

Durch die vorstehend beschriebenen Maßnahmen läßt sich also bei den beschriebenen CTD-Leitungen erreichen,daß durch eine sukzessive Ladungsaufteilung Streuungen bei der Herstellung minimiert werden können. Entsprechend dem in der Regel vorgegebenen Ladungsaufteilungsverhältnis sind hierfür zwar eine gewisse Mindestzahl von CTD-Elementen erforderlich, jedoch kann dies in Anbetracht der zu erzielenden Genauigkeit bei der praktischen Realisierung solcher Anordnungen durchaus in Kauf genommen werden.

2 Patentansprüche
1 Figur

Patentansprüche

1. Aus mehreren CTD-Elemtenten bestehende CTD-Leitung, bei der zur Ladungsaufteilung in Richtung des Ladungstransportes verlaufende Trennstege, insbesondere nach Art von Dickoxid-Stegen oder channel-stop-Gebieten, aufgebracht sind, dadurch gekennzeichnet, daß zur Erzielung eines vorgegebenen Ladungsaufteilungsverhältnisses die Ladungsaufteilung in mehr als einem Schritt erfolgt, derart, daß für aufeinanderfolgende Teilungsschritte die Trennstege (DOX) so angeordnet sind, daß sich für den einzelnen Schritt eine Ladungsaufteilung im Verhältnis von etwa 1:1 ergibt, und daß zwischen den Teilungsstufen ($A_1$, $B_1$, $A_2$, $B_2$, $A_3$, $B_3$) Summations-Abschnitte ($C_1$, $C_2$, $C_3$) vorgesehen sind, in denen mit Ausnahme von nur einer Teilladung ($A_1$, $A_2$, $A_3$) sämtliche übrigen Teilladungen ($B_1$; $B_1+B_2$; $B_1+B_2+B_3$) summiert werden.

2. CTD-Leitungen nach Anspruch 1, dadurch gekennzeichnet, daß für den den kleineren Ladungsanteil führenden Teilwert ($A_4$) eine Kanalaufweitung (3) vorgesehen ist.

Hka 1 Toi / 20.05.1980

1/1

0040423